# EUROPÄISCHE PATENTSCHRIFT

(11) **EP 0 387 574 B1**
(45) Veröffentlichungstag und Bekanntmachung des Hinweises auf die Patenterteilung: **02.06.1993**
(21) Anmeldenummer: 90103638.4
(22) Anmeldetag: 25.02.1990
(51) Int. Cl.: C30B 15/02, C30B 35/00

(54) **Vorrichtung zum Dosieren von Siliciumschmelzen**
Apparatus for metering silicon melt
Appareillage pour le dosage de silicium fondu

(30) Priorität: 11.03.1989 DE 3907916
(43) Veröffentlichungstag der Anmeldung: 19.09.1990
(73) Patentinhaber: BAYER AG, 51368 Leverkusen (DE)
(72) Erfinder: Lange, Horst, Dr., D-4630 Bochum 1 (DE); Gebauer, Klaus, Dr. BAYER ITALIA S. p. A., I-20100 Milano (IT)

(56) Entgegenhaltungen:
- EP-A- 0 007 063
- EP-A- 0 021 385
- EP-A- 0 065 373
- EP-A- 0 258 818
- EP-A- 0 268 166
- GB-A- 2 173 493
- US-A- 2 893 847
- US-A- 4 219 139

## Beschreibung

Die vorliegende Erfindung betrifft eine Vorrichtung zum Dosieren von Siliciumschmelzen, bestehend aus einem Vorratsund einem Auslaufteil, welche in einer Abdichtungszone durch einen geeigneten Verschluß getrennt bzw. verbunden werden können.

Sowohl bei der Reinigung als auch bei der Weiterverarbeitung von Siliciumschmelzen, z.B. in Kristallisationsprozessen, ist es notwendig, im diskontinuierlichen Betrieb eine bestimmte Menge der Schmelze aus einem Vorratsbehälter zu dosieren oder im kontinuierlichen Schmelzbetrieb einen bestimmten Massenstrom einer Siliciumschmelze einzustellen und zu regeln.

Es sind verschiedene Verfahren zur Dosierung von Siliciumschmelzen vorgeschlagen worden. Gemäß D. Helmreich, "The Wacker Ingot Casting Process" in C.P. Khattak, K.V. Ravi (ed.) "Silicon Processing for Photovoltaics II", Elsevier Science Publishers BV, North Holland Physics Publishing, Amsterdam, 1987 wird die Si-Schmelze aus einem Kipptiegel heraus gegossen. Dabei ist aber aufgrund der Kippbewegung des Tiegels ein streng kontinuierliches Nachchargieren und Aufschmelzen festen Materials während des Gusses nur sehr schwer möglich. Da das feste Silicium eine geringere Dichte als seine Schmelze aufweist, schwimmt das nachchargierte feste Material zunächst auf, so daß hierdurch der Gußprozeß gestört wird.

Von T. Daud, A.H. Kachare "Advanced Czochralski Silicon-Growth Technology for Photovoltaic Moduls" Flat Plate Solar Array Project; Bericht DOE/JPL-1012-70 JPL Publication 82-35 (1982) wird vorgeschlagen, flüssiges Silicium aus einer Kammer, die einen Schmelzevorratstiegel enthält, durch einen auf die Schmelzbadoberfläche wirkenden regelbaren Gasdruck über ein eingetauchtes, U-förmig ausgebildetes Steigrohr in den Kristallisationstiegel zu dosieren.

In der EP-A 0 013 985 wird das Konzept, flüssiges Silicium unter der Einwirkung eines Gasdruckes auf eine Vorratsschmelze in einem geschlossen ausgebildeten Schmelzvorratsgefäß durch eine Kristallisationswanne mündende Ausflußöffnung überzupressen, ebenfalls angesprochen. Schließlich wird in der DE-A 3 136 454 das Überpressen von flüssigem Silicium unter der Einwirkung eines Gasdruckes auf die Schmelzbadoberfläche in einem als Druckkammer ausgebildeten Schmelzevorratstiegel durch ein Überführrohr in einen Schmelzetrog beschrieben.

Ein grundsätzlicher Nachteil der auf der Gasdruckförderung von flüssigem Silicium basierenden Verfahren zur Dosierung oder Nachchargierung von Siliciumschmelzen ist, daß das vom Schmelzevorratsgefäß zum Prozeßgefäß führende Überlaufrohr (bzw. eine Überlaufrinne oder -nase) zusätzlich beheizt werden muß, um eine vorzeitige Kristallisation und damit eine Unterbrechung des Siliciumstroms zu verhindern. Die erforderliche Zusatzheizung des Überlaufrohres macht es zudem sehr schwierig, eine Gasdruckförderung der Siliciumschmelze zu realisieren, wenn auf der Seite des Prozeßgefäßes ein sehr gutes Vakuum gefordert wird.

Bei Gußprozessen wie z.B. dem Kokillenguß treten weitere prinzipielle Probleme der Gasdruckförderung von Siliciumschmelzen hervor. Da eine impulsartige Druckbeaufschlagung auf das Vorratsgefäß durch das aufzubauende Gaspolster nicht möglich ist, kommt es zu Beginn des Dosiervorganges regelmäßig zu einer Gußverzögerung, bis der beabsichtigte Schmelzfluß einsetzt. Das Inertgas muß erst in den Kessel strömen, der den Schmelzevorratstiegel enthält, und den gewünschten, an einem Regelventil eingestellten Gieß- bzw. Dosierdruck aufbauen. Danach setzen sich insbesondere bei großen Schmelzchargen die Siliciummengen nur langsam in Bewegung und strömen durch ein Überlaufrohr oder einen Siphon in das Prozeßgefäß. Auch kommt es am Ende des Dosiervorganges nach Druckabsenkung zu einem unerwünschten Nachlauf des flüssigen Siliciums, so daß der Dosierprozeß zeitlich und mengenmäßig insgesamt nur schwer präzise zu steuern ist.

Gemäß der EP-A 0 013 985 wird flüssiges Silicium aus einem Vorratsgefäß durch Einführen eines Verdrängungskörpers über eine Auslauföffnung in eine Kristallisationswanne dosiert. Auch hier müssen die Überlaufrohre oder Überlaufrinnen, über die die Siliciumschmelze vom Vorratstiegel in den Prozeßtiegel gelangt, zusätzlich beheizt werden.

Diese Heizungen erfordern nebst der dazugehörigen thermischen Isolation nicht nur relativ viel Raum, sondern verursachen darüber hinaus zusätzliche Material- und Energiekosten. Schließlich sollte eine direkter Kontakt zwischen Verdrängungskörper und Schmelzevorratsgefäß vermieden werden, um der Gefahr des Verbackens oder Verklebens wirkungsvoll zu begegnen.

Daher bleibt stets eine Restmenge flüssigen Siliciums am Boden des Dosiergefäßes bzw. als Film zwischen Dosierkolben und Tiegelwand zurück. Der Vorratstiegel kann also auch bei maximalem Eintauchen des Verdrängungskörpers nicht vollständig entleert werden.

Gemäß der EP-A 0 013 985 wird flüssiges Silicium mittels eines Kapillarrohres oder eines Kapillarsystems aus einem Schmelzevorratstiegel in eine Kristallisationswanne überführt. Auch hier muß das Kapillarsystem durch Zusatzheizungen auf Siliciumschmelztemperatur gehalten werden. Weitere Nachteile bei diesem Verfahren sind, daß Steighöhe, Fördervolumen und Fördergeschwindigkeit durch die Kapillarkräfte eng begrenzt sind. Besonders nachteilig ist weiterhin, daß ein durch Kapillarkräfte erzeugter Siliciumschmelzestrom nicht geregelt werden kann.

Schließlich kommt es zu Beginn der Schmelzedosierung nach dem Eintauchen des Kapillarrohres in die Vorratsschmelze zu einer Zeitverzögerung, bis das flüssige Silicium durch die Kapillare zum Prozeßgefäß gewandert ist. Ferner ist man bei der Konzeption eines derartigen Kapillarsystems auf Werkstoffe beschränkt, die von einer Siliciumschmelze sehr gut benetzt werden. Hierzu zählen z.B. Siliciumcarbid,, siliciumcarbidbeschichteter Graphit oder siliciumimprägnierter Graphit. Abgesehen von einfachen Geometrien lassen sich komplizierte Bauteile aus diesen Werkstoffen nur mit sehr hohem Aufwand herstellen.

In der EP-A 0 065 373 wird zur Dosierung einer Siliciumschmelze ein Vorratstiegel offenbart, der durch einen Hahn als Tropftrichter ausgebildet ist; die zur Herstellung eines funktionsfähigen Systems erforderlichen Werkstoffe werden nicht angegeben.

In der EP-A 0 055 310 wird zum kontinuierlichen Nachchargieren einer Siliciumschmelze vom Vorratstiegel in eine Kokille (kontinuierliches Gießen) ein Tiegel vorgeschlagen, aus dem aus einer nicht verschließbaren Bodenöffnung ein Schmelzestrom läuft. Ebenso arbeitet ein Schmelzenachchargierverfahren, das Bestandteil einer schematisch dargestellten Apparatur zur Herstellung von Bandkristallen aus Halbleiterschmelzen in der EP-A 0 230 617 ist.

Es ist jedoch offensichtlich, daß diese Dosiertechnik in nur stark beschränkter Weise aktive Dosierprozesse, in denen die auslaufende Schmelzmenge genau geregelt werden muß, zuläßt. Ferner ist es nicht möglich, den Schmelzstrom zu beliebigen Zeiten schnell und abrupt zu unterbrechen oder wieder in Gang zu setzen, falls dies aus Sicherheitsgründen oder technischen Gründen erforderlich sein sollte. Vielmehr muß der Tiegel entweder vollständig geleert oder die im Tiegel befindliche Schmelzmenge durch Absenken der Temperatur erstarrt werden. In beiden Fällen wird der Schmelzefluß nur mit einer erheblichen Zeitverzögerung unterbrochen.

Eine Darstellung eines ähnlich arbeitenden Dosierverfahrens ist in der US-A 4 272 488 zu finden. Aus der metallurgischen Technik ist ein Dosierverfahren allgemein bekannt, nach dem Schmelzflüssigkeit aus einen Vorratstiegel, der mit einem in eine Öffnung im Tiegelboden eingelassenen beweglichen Verschlußstopfen versehen ist, in das Prozeßgefäß gefüllt wird. Durch gesteuertes Heben und Senken des Verschlußstopfens kann eine definierte Schmelzmenge durch die Bodenöffnung des Vorratstiegels in das Prozeßgefäß fließen. So gehört es in vollautomatischen Gießanlagen zum Stand der Technik, die Gußformen auf diese Weise zu befüllen; vgl. z.B. M. Ogrissek, "Gießeinrichtungen für Gußeisen - bestehende und neue Steuersysteme und deren Anwendung", Giesserei 70 (9), 268 - 274 (1983).

Neben den offensichtlichen Vorteilen eines solchen Systems ist auch dessen Störanfälligkeit bekannt.

Hauptursachen für Störungen der Schmelzedosierung sind:
öffnung des Vorratstiegels
- Undichtigkeiten des Stopfenverschlusses
- Bruch des Stopfens
- Verschleiß durch thermische Einflüsse (Temperaturwechselbeanspruchung), chemische Korrosion oder mechanischen Abrieb

Bei der Dosierung von Siliciumschmelzen, deren chemische Reinheit eine Weiterverarbeitung des Materials zu Solarzellen erlauben soll, kommt erschwerend hinzu, daß die Schmelze weder durch das Stopfen- noch durch das Tiegelmaterial in nicht tolerierbarer Weise verunreinigt werden darf. Übliche Feuerfestmassen , die für Stopfendosierungen, z.B. in der Eisenmetallurgie verwendet werden, scheiden aus. Sie werden durch die chemisch sehr aggressive Siliciumschmelze rasch angegriffen, so daß der Verschluß schnell funktionsuntüchtig wird. Durch den korrosiven Angriff wird ferner die Reinsiliciumschmelze so stark verunreinigt, daß das Silicium seine chemische Reinheit, die zur Solarzellenherstellung erforderlich ist, eingebüßt.

Eine Stopfendosierung für Siliciumschmelzen ist aus der EP-A 0 007 063 bekannt; das Werkstoffproblem, das mit der Herstellung eines zuverlässig funktionierenden und langlebigen Stopfendosierverschlusses für Siliciumschmelzen verbunden ist, wird hier jedoch nicht behandelt, ebenso werden die zur Herstellung der Stopfendosierung erforderlichen Werkstoffe nicht angegeben.

Da Graphit sehr einfach und leicht bearbeitet werden kann, erscheint seine Anwendung zur !Herstellung von Stopfendosiertiegeln sehr attraktiv. Graphitqualitäten mit ausreichender Resistenz gegenüber Siliciumschmelzen sind kommerziell erhältlich. Im Kontakt mit flüssigem Silicium bildet sich auf der Graphitoberfläche eine dünne Siliciumcarbidschicht, wobei häufig auch ein Einsickern des Silicium in die Poren des Werkstoffes beobachtet werden kann. Diese SiC-Bildung führt an den Kontaktstellen zweier aufeinandersitzender Dichtflächen aus Graphit dazu, daß der Dosierstopfen mit dem Tiegel fest verbackt; damit wird der Dosierverschluß funktionsunfähig.

Aufgabe dieser Erfindung ist die Bereitstellung einer Vorrichtung, die die beschriebenen Nachteile nicht aufweist.

Es wurde nun überraschend gefunden, daß die obengenannten Anforderungen erfüllt wird, Stopfendosierverschlüsse für Siliciumschmelzen, wobei der Verschlußbereich aus beliebigen Kombinationen der Werkstoffe Siliciumcarbid, Siliciumnitrid, Siliciumoxinitrid, Bornitrid, einem Werkstoff, der durch Glühen von kieselsolgebundenem Siliciumpulver in einer Stickstoffatmosphäre entsteht und dessen Herstellung in der EP-A 268 166 beschrieben wird, mit Graphit hergestellt werden können.

Die Kombination Graphit-Graphit ist aus den oben diskutierten Gründen untauglich.

Gegenstand dieser Erfindung ist somit eine Vorrichtung zum Dosieren von Siliciumschmelzen, bestehend aus einem Vorrats- (1) und einem Auslaufteil (2), welche in einer Abdichtungszone (3) durch einen geeigneten Verschluß (4) getrennt bzw. verbunden werden können, dadurch gekennzeichnet, daß sowohl der Vorrats- (1) und Auslaufteil (2) in der Abdichtungszone (3) als auch der Verschluß (4) jeweils aus einem oder mehrerer der Werkstoffe Graphit, Si₃N₄, Si₂N₂O, SiC und BN bestehen oder damit oberflächebeschichtet sind, wobei beliebige Werkstoffkombinationen mit Ausnahme von Graphit/Graphit möglich sind und ein Teil aus Graphit besteht oder damit oberflächen beschichtet ist.

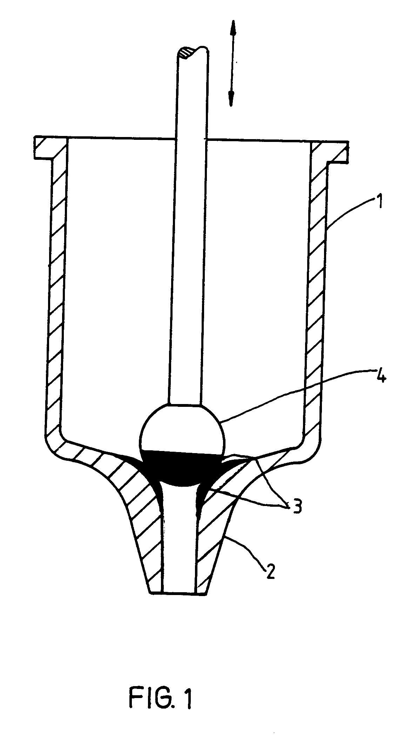

Eine Ausführungsform der erfindungsgemäßen Vorrichtung ist in Fig. 1 schematisch dargestellt.

Es ist überraschend, daß aus der Materialpaarung SiC-Graphit ein funktionsfähiger Verschluß gefertigt werden kann, bei dem die unerwünschten Anbackungen öder Verbackungen nicht auftreten.

Es ist weiterhin völlig überraschend, daß auch bei unterschiedlichen thermischen Ausdehnungskoeffizienten bei Einsatz voneinander verschiedener Werkstoffe die Funktionsfähigkeit und die Funktionssicherheit des Stopfendosierverschlusses in keiner Weise beeinträchtigt. Da bekannt ist, daß der Werkstoff Bornitrid eine hochreine Siliciumschmelze mit Bor dotiert, wird man dieses Material vorteilhaft dann einsetzen, wenn eine Bordotierung des Siliciums erwünscht ist oder aber keine Rolle spielt.

Stopfendosierverschlüsse, deren Dichtungsflächen aus Kombinationen der obengenannten Werkstoffkombinationen bestehen, überstehen ohne weiteres mehrere Schmelz-/Gefrierzyklen und behalten auch nach Reinigung der Oberflächen von anhaftendem Silicium durch chemisches Ätzen mit Natronlauge oder Flußsäure/Salpetersäure-Gemischen ihre volle Funktionsfähigkeit bei.

Die abdichtenden Verschlüsse können grundsätzlich aus den jeweiligen Vollmaterialien gefertigt werden; es ist jedoch auch möglich, auf die Dichtflächen eine Beschichtung mit SiC, Si₃N₄-, Si₂N₂O- oder BN-Pulver oder aus beliebigen Gemischen dieser Pulver aufzutragen. Die Pulverbeschichtungen bewähren sich besonders, wenn sowohl Tiegel als auch Dosierstopfen aus Graphit gefertigt werden, da sie zwischen den Dichtflächen eine Schutzschicht bilden, die mit Silicium nicht reagiert und damit das Verbacken des Dosierstopfens verhindern. Ebenso ist es möglich, auf die Graphit- oder Keramikdichtflächen SiC-, Si₃N₄-, Si₂N₂O- oder BN-Schutzschichten durch Chemical-Vapour-Deposition (CVD) aufzubringen, um eine leichte mechanische Beweglichkeit der Dichtflächen zusammen mit vollständiger Dichtigkeit gegenüber einer Siliciumschmelze zu gewährleisten. Weiterhin können die genannten CVD-Schutzschichten auch mit den beschriebenen Pulverbeschichtungen kombiniert werden.

Aufgrund der sehr leichten Bearbeitungsmöglichkeit von Graphit kann einer wirtschaftlichen und einfachen Fertigung einer Stopfendosierung Rechnung getragen werden, wenn der Schmelztiegel als das größere und komplexere Teil aus Graphit, der Dosierstopfen als das kleinere und meist weniger komplexe Bauteil aus einem wie oben beschriebenen passenden Gegenwerkstoff gefertigt wird.

Es ist auch denkbar, Tiegel und Verschlußstopfen aus anderen als den hier genannten Materialien herzustellen und die Bauteiloberflächen ganz oder teilweise - z.B. nur im Benetzungsbereich der Siliciumschmelze - oder nur die Kontaktflächen des Bodenverschlusses - durch CVD- Schutzschichten oder mit Pulverschutzschichten eines oder mehrerer der hier beschriebenen Materialien vor dem Kontakt mit der Siliciumschmelze zu schützen. Es ist ebenso möglich, lediglich die Kontaktstellen oder Kontaktflächen des Stopfenverschlusses mit eingelegten Ringen oder Hülsen aus den beschriebenen Vollmaterialien der geeigneten Werkstoffkombinationen zu versehen, um einen funktionsfähigen Stopfendosierverschluß zu erhalten.

Besonders gute Ergebnisse werden erreicht, wenn der Vorrats (1)- und Auslaufteil (2) aus Graphit besteht oder damit oberflächenbeschichtet ist und der Verschluß (4) aus Si₂N₂O oder aus Si₃N₄ besteht oder damit oberflächenbeschichtet ist.

Ebenso ist die Ausführungsform für bestimmte Fälle bevorzugt, gemäß der der Vorrats- (1) und Auslaufteil (2) aus Si₃N₄ besteht oder damit oberflächenbeschichtet ist und der Verschluß (4) aus Graphit besteht oder damit oberflächenbeschichtet ist.

Eine besonders bevorzugte Ausführungsform dieser Erfindung ist eine Vorrichtung, bei der der Vorrats- (1) und Auslaufteil (2) aus Graphit besteht oder damit oberflächenbeschichtet ist und der Verschluß (4) aus Si₃N₄ besteht oder damit oberflächlich beschichtet ist.

Eine günstige Ausführungsform des Dosierverschluusses besteht darin, ihn als Schliffverbindung von Tiegelöffnung und Dosierstopfen auszuführen. Bei jeweils passend eingeschliffener Hülse in der Auslauföffnung kann der abdichtende Teil des Dosierstopfens z.B. als kugelförmiger, kegelförmiger oder kegelstumpfförmiger Kernschliff ausgeführt werden. Neben Verschlüssen, die ausgesprochene Dichtflächen aufweisen, können auch Verschlüsse, die nur sehr schmale Dichtzonen oder Verschlüsse die minimierte Kontaktflächen durch Ausführung als Ringdichtungen besitzen, erfolgreich zur Dosierung von Schmelzen eingesetzt werden, sofern das Dosiersystem aus den hier beschriebenen Werkstoffkombinationen angefertigt ist. Ferner kann das untere Ende des Dosierverschlusses auf einer plan gearbeiteten Platte mit einem oder mehreren exzentrisch angebrachten Löchern bestehen, so daß durch geeignetes Verdrehen der Verschlußplatte diese Löcher mit entsprechenden Austrittsöffnungen im Tiegelboden ganz oder teilweise zur Deckung gebracht werden können und die Siliciumschmelze auslaufen kann.

Ebenso besteht bei dieser Version die Möglichkeit, die Verschlußplatte und den Tiegelboden mit Spaltöffnungen variabler Breite zu versehen.

Die erfindungsgemäße Vorrichtung kann ebenfalls in Dosiersystemen eingesetzt werden, die auf der Verdrängung der Siliciumschmelze durch Eintauchen eines Verdrängungskörpers beruhen. Wenn Vorratsgefäß und Verdränger aus den oben beschriebenen Materialkombinationen hergestellt werden, läßt sich ein Verbacken bei Kontakt beider Teile wirkungsvoll unterbinden.

Es ist damit leicht ersichtlich, daß es die genannten Werkstoffkombinationen ermöglichen, Geometrie und Ausführungsform eines derartigen Dosierverschlusses in weiten Grenzen zu ändern. Die oben beschriebenen Ausführungsformen sowie das Beispiel sind daher lediglich als illustrierende Beispiele zu sehen und stellen mithin in keiner Weise eine Einschränkung der Erfindungsgedankens dar.

### Beispiel

Ein mit einer Bodenöffnung (Schliffhülse) versehener Graphitschmelztiegel wird mit einem passend eingeschliffenen Siliciumnitridstopfen (Kernschliff) verschlossen und anschließend mit Siliciumgranulat gefüllt. Der Dosiertiegel ist in Zeichnung 1 schematisch dargestellt. Nach dem vollständigen Aufschmelzen des Siliciums wird die Temperatur der Schmelze zunächst 30 min. lang bei 1450°C gehalten, wobei kein Austreten oder Aussickern der Siliciumschmelze durch den Bodenverschluß zu bemerken ist. Durch wiederholtes Ziehen und Schließen des Siliciumnitridstopfens kann jeweils eine definierte Menge der Siliciumschmelze aus dem Tiegel abgelassen werden. Nach jedem Dosiervorgang kann beobachtet werden, daß der Verschluß immer wieder dicht schließt; es läuft oder sickert kein Silicium nach.

Der Dosiertiegel kann unbedenklich mit geschlossener Dosieröffnung und bei Gegenwart einer Restsiliciumschmelze abgekühlt werden; die erstarrende Restschmelze ist ohne Einfluß auf die Gebrauchstüchtigkeit des Dosierstopfens beim Wiederaufschmelzen. Wird der Tiegelinhalt vollständig entleert und der Tiegel mit herausgezogenem Dosierstopfen abgekühlt, müssen die Dichtungsflächen vor dem Wiedereinsatz z.B. durch Abätzen mit einem Gemisch aus gleichen Volumenteilen 20 Gew.-%iger Flußsäure und 63 Gew.-%iger Salpetersäure von anhaftenden Siliciumresten befreit werden. Auch bei einem solcherart gereinigten Dosierverschluß wird wieder leichte Dosierbarkeit der Siliciumschmelze bei jeweils immer wieder dicht schließendem Siliciumnitridstopfen beobachtet. Der Dosierverschluß behält seine volle Funktionsfähigkeit ohne weiteres über mehr als 10 Schmelz-Abkühl- und Reinigungszyklen bei.

## Patentansprüche

1. Vorrichtung zum Dosieren von Siliciumschmelzen, bestehend aus einem Vorrats- (1) und einem Auslaufteil (2), welche in einer Abdichtungszone (3) durch einen geeigneten Veschluß (4) getrennt bzw. verbunden werden können, dadurch gekennzeichnet, daß sowohl der Vorrats-(1) und Auslaufteil (2) in der Abdichtungszone (3) als auch der Verschluß (4) jeweils aus einem oder mehrerer der Werkstoffe Graphit, Si₃N₄, Si₂N₂O, SiC und BN bestehen oder damit oberflächenbeschichtet sind, wobei beliebige Werkstoffkombinationen mit Ausnahme von Graphit/-Graphit möglich sind und ein Teil aus Graphit besteht oder damit oberflächenbeschichtet ist.

2. Vorrichtung gemäß Anspruch 1, dadurch gekennzeichnet, daß der Vorrats- (1) und Auslaufteil (2) aus Graphit besteht oder damit oberflächenbeschichtet ist und der Verschluß (4) aus Si₂N₂O besteht oder damit oberflächenbeschichtet ist.

3. Vorrichtung gemäß Anspruch 1, dadurch gekennzeichnet, daß der Vorrats- (1) und Auslaufteil (2) aus Si₃N₄ besteht oder damit oberflächenbeschichtet ist und der Verschluß (4) aus Graphit besteht oder damit oberflächenbeschichet ist.

4. Vorrichtung gemäß Anspruch 1, dadurch gekennzeichnet, daß der Vorrats- (1) und Auslaufteil (2) aus Graphit besteht oder damit oberflächenbeschichtet ist und der Verschluß (4) aus Si₃N₄ besteht oder damit oberflächenbeschichtet ist.

## Claims

1. Apparatus for metering silicon melts, comprising a supply module (1) and a discharge module (2) which can be separated or connected in a sealing zone (3) by means of a suitable seal (4), characterised in that the supply module (1) and discharge module (2) in the sealing zone (3) and also the seal (4) each consist of one or several of the materials graphite, Si₃N₄, Si₂N₂O, SiC and BN or are surface-coated therewith, whereby any combinations of materials are possible with the exception of graphite/graphite, and one module consists of graphite or is surface-coated therewith.

2. Apparatus according to Claim 1, characterised in that the supply module (1) and discharge module (2) consists of graphite or is surface-coated therewith and the seal (4) consists of Si₂N₂O or is surface-coated therewith.

3. Apparatus according to Claim 1, characterised in that the supply module (1) and discharge module (2) consists of Si₃N₄ or is surface-coated therewith and the seal (4) consists of graphite or is surface-coated therewith.

4. Apparatus according to Claim 1, characterised in that the supply module (1) and discharge module (2) consists of graphite or is surface-coated therewith and the seal (4) consists of Si₃N₄ or is surface-coated therewith.

## Revendications

1. Dispositif doseur de masses fondues de silicium, constitué d'une partie réservoir (1) et d'une partie d'écoulement (2), qui peuvent être séparées ou mises en communication dans une zone d'étanchéité (3) par un obturateur (4) approprié, caractérisé en ce que la partie réservoir (1) et la partie d'écoulement (2) dans la zone d'étanchéité (3) de même que l'obturateur (4) sont constitués chacun d'un ou plusieurs des matériaux graphite, Si₃N₄, Si₂N₂O, SiC et BN ou sont revêtus en surface par ces matériaux, des associations quelconques de matériaux à l'exception de l'association graphite/graphite étant possibles et une partie étant constituée de graphite ou étant revêtue de graphite en surface.

2. Dispositif suivant la revendication 1, caractérisé en ce que la partie réservoir (1) et la partie d'écoulement (2) sont réalisées en graphite ou sont revêtues de graphite en surface et l'obturateur (4) est réalisé en Si₂N₂O ou est revêtu en surface de ce matériau.

3. Dispositif suivant la revendication 1, caractérisé en ce que la partie réservoir (1) et la partie d'écoulement (2) sont réalisées en Si₃N₄ ou sont revêtues de Si₃N₄ en surface et l'obturateur (4) est réalisé en graphite ou est revêtu de graphite en surface.

4. Dispositif suivant la revendication 1, caractérisé en ce que la partie réservoir (1) et la partie d'écoulement (2) sont réalisées en graphite ou sont revêtues de graphite en surface et l'obturateur (4) est réalisé en Si₃N₄ ou est revêtu de Si₃N₄ en surface.
